Europäisches Patentamt

European Patent Office

Office européen des brevets

(11) Numéro de publication : **0 536 027 A1**

(19)

# (12) DEMANDE DE BREVET EUROPEEN

(21) Numéro de dépôt : **92402635.4**

(22) Date de dépôt : **25.09.92**

(51) Int. Cl.⁵ : **H03L 7/093**

(30) Priorité : **04.10.91 FR 9112228**

(43) Date de publication de la demande :
**07.04.93 Bulletin 93/14**

(84) Etats contractants désignés :
**DE FR GB IT NL**

(71) Demandeur : **THOMSON-CSF**
**51, Esplanade du Général de Gaulle**
**F-92800 Puteaux (FR)**

(72) Inventeur : **Gaudin, Daniel**
**Thomson-CSF, SCPI-Cedex 67**
**F-92045 Paris la Défense (FR)**
Inventeur : **Leclere-Allain, Alain**
**Thomson-CSF, SCPI-Cedex 67**
**F-92045 Paris la Défense (FR)**

(74) Mandataire : **Benoit, Monique et al**
**THOMSON-CSF, SCPI, B.P. 329, 50, rue**
**Jean-Pierre Timbaud**
**F-92402 Courbevoie Cédex (FR)**

(54) Procédé et dispositif d'annulation de l'erreur de phase sur le déphasage entre les signaux d'entrée et de sortie d'une boucle à verrouillage de phase.

(57)    La présente invention concerne un procédé et un dispositif d'annulation de l'erreur de phase existant sur le déphasage entre les signaux d'entrée et de sortie d'une boucle à verrouillage de phase (PLL) composée classiquement d'un comparateur de phase (1), d'un filtre de boucle (2), d'un amplificateur de tension (3 ; 3') et d'un oscillateur (4) commandé par la tension de sortie de l'amplificateur (VCO).

L'invention consiste, après accrochage de la boucle sur une fréquence, à superposer à la tension d'entrée de l'amplificateur (3 ; 3'), une tension dite de décalage de façon à obtenir une tension à la sortie du comparateur de phase (1) qui soit représentative d'une erreur de phase nulle, tout en conservant la fréquence d'accrochage.

Avantageusement, l'annulation se fait automatiquement en commandant la tension de décalage par la tension de sortie du comparateur de phase (1) au moyen d'une boucle de constante de temps supérieure à la boucle principale de la PLL.

L'invention est particulièrement intéressante dans le domaine de la récupération de porteuse pour une détection synchrone.

FIG.5

EP 0 536 027 A1

La présente invention concerne un procédé et un dispositif d'annulation de l'erreur de phase existant sur le déphasage entre les signaux d'entrée et de sortie d'une boucle à verrouillage de phase ou PLL (Phase Locked Loop), notamment pour régénérer une porteuse très pure.

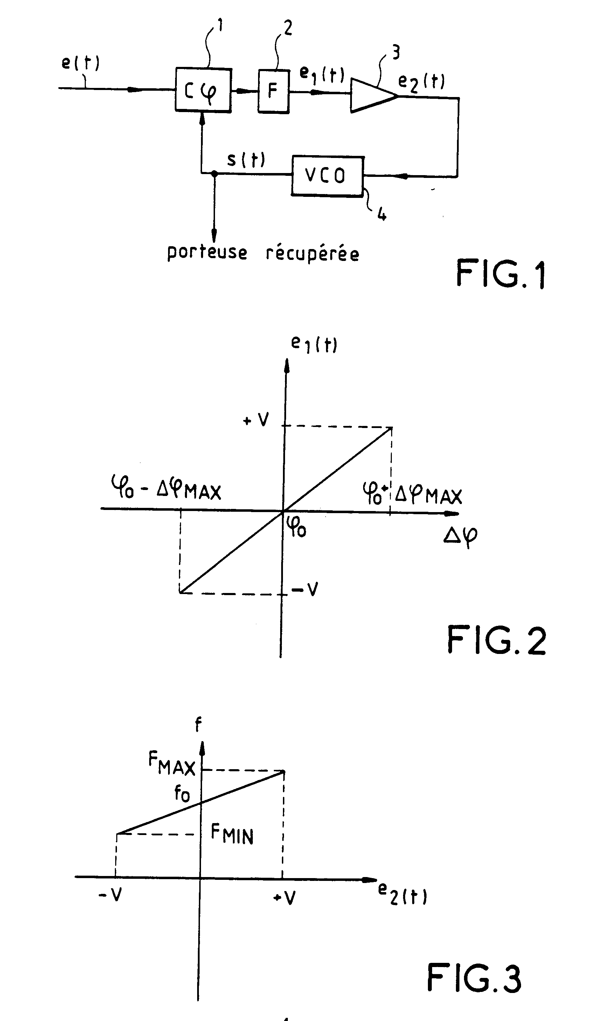

Dans le domaine de la démodulation cohérente, pour laquelle il est nécessaire d'effectuer le produit du signal modulé par un signal de fréquence identique à celle de la porteuse, il est courant de recourir à une PLL afin de récupérer la porteuse à la réception. La figure 1 montre une boucle à verrouillage de phase classique comportant un comparateur de phase 1 recevant sur l'une de ses entrées le signal modulé e(t), et sur l'autre, le signal s(t) issu de la boucle et dont la fréquence doit être celle de la porteuse. Le comparateur de phase 1, suivi classiquement d'un filtre de boucle 2, délivre une tension $e_1(t)$ continue et fonction de l'erreur de phase $\Delta\varphi$ existant sur le déphasage $\varphi_o$ entre les signaux e(t) et s(t), suivant par exemple une caractéristique du type représenté sur la figure 2. Après amplification par un amplificateur 3, la tension $e_1(t)$ devenue $e_2(t)$, alimente un oscillateur de fréquence 4, par exemple du type VCO (initiales anglo-saxonnes pour "oscillateur commandé en tension") délivrant le signal s(t) à la fréquence f fonction de $e_2(t)$, selon une caractéristique du type représenté sur la figure 3.

Les caractéristiques données à titre d'exemples sur les figures 2 et 3 montrent que, pour une fréquence f délivrée par l'oscillateur 4 et différente de la fréquence $f_o$ centrale de cet oscillateur, il existe une erreur de phase $\Delta\varphi$ non nulle sur le déphasage $\varphi_o$ existant entre les signaux e(t) et s(t). Le rôle de l'amplificateur 3 est de fournir un gain de boucle A permettant de réduire d'un rapport environ égal à A cette erreur de phase $\Delta\varphi$ afin que le déphasage entre les signaux d'entrée et de sortie de la PLL se rapproche le plus de la valeur $\varphi_o$, sachant que l'optimum est obtenu pour une annulation totale de $\Delta\varphi$. Cependant, un gain de boucle important est en général incompatible avec la stabilité de la boucle et l'erreur de phase $\Delta\varphi$ n'est jamais totalement annulée. Or, dans certaines applications, la présence de $\Delta\varphi$ peut être indésirable. C'est le cas de toute modulation d'amplitude avec ou sans porteuse (modulation DBL ou double bande latérale) pour laquelle la détection cohérente, qui consiste à multiplier le signal module par le signal s(t), affecte le signal démodule d'un facteur $\cos\Delta\varphi$ qui peut varier selon par exemple une dérive thermique de la fréquence du modulateur. Certaines valeurs de déphasage risquent alors de perturber, voire d'annuler ce signal démodulé.

Un objet de l'invention est d'annuler l'erreur de phase $\Delta\varphi$ existant sur le déphasage entre les signaux d'entrée et de sortie de la boucle à verrouillage de phase.

Un autre objet de l'invention est d'effectuer cette annulation de façon automatique pour compenser les dérives thermiques possibles.

Plus précisément, l'invention concerne un procédé d'annulation de l'erreur de phase sur le déphasage entre le signal d'entrée et le signal de sortie d'une boucle à verrouillage de phase tel que décrit dans les revendications 1 et 2.

L'invention propose également un dispositif permettant la mise en oeuvre du procédé, tel que décrit dans les revendications 3 à 6.

L'invention, ainsi que ses avantages, sera mieux comprise au vu de la description suivante, en référence aux figures annexées :

- La figure 1 est le schéma d'une boucle à verrouillage de phase classique ;
- Les figures 2 et 3 sont des exemples de caractéristique d'un comparateur de phase et d'un oscillateur commande en tension ;
- La figure 4 est un mode de réalisation possible d'un dispositif d'annulation de l'erreur de phase sur le déphasage selon l'invention ;
- La figure 5 est un second mode de réalisation du dispositif selon l'invention, dans lequel l'annulation précédente s'effectue automatiquement.

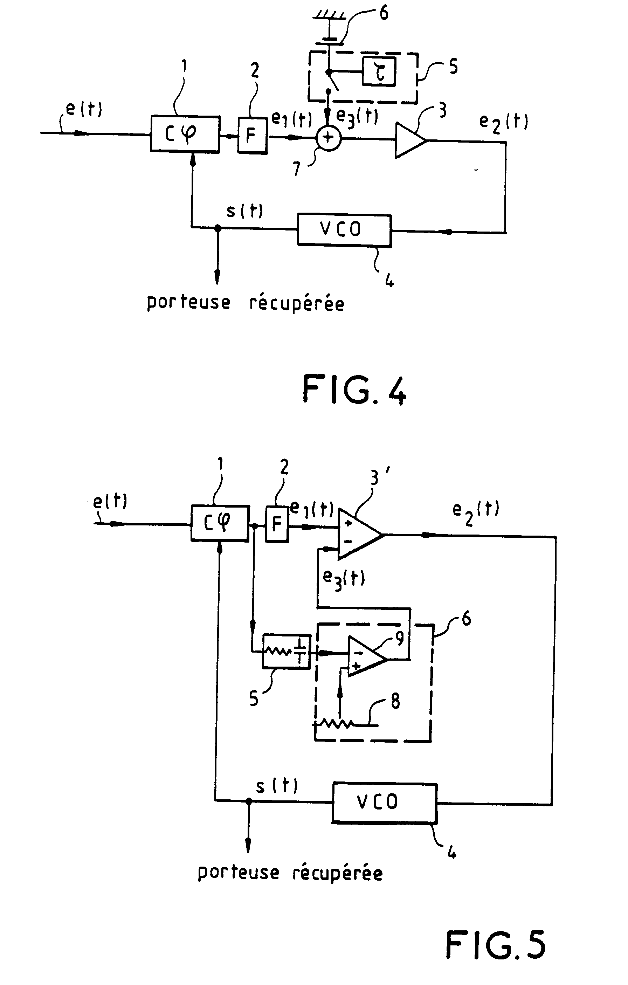

La figure 4 représente la même boucle à verrouillage de phase que celle de la figure 1 pour laquelle une tension $e_3(t)$ constante, dite tension de décalage, est superposée à la tension $e_1(t)$ issue du comparateur de phase 1 et de son filtre de boucle 2 associé. Si $e_3(t)$ est nulle, on retombe dans le cas d'une PLL classique. Supposons à présent que la boucle soit accrochée sur une certaine fréquence, par exemple $F_{MAX}$. Les figures 2 et 3, applicables pour un gain unitaire de l'amplificateur 2, montrent que l'on a alors

$$e_2(t) = e_1(t) = + V$$
$$\Delta\varphi = \varphi_o + \Delta\varphi_{max}.$$

Si l'on donne à $e_3(t)$ la valeur +V, l'équilibre de la boucle sera maintenu, c'est-à-dire $e_2(t)$ sera égal à +V, dans le cas où $e_1(t)$ s'annule, c'est-à-dire, compte-tenu de l'exemple pris à la figure 2, dans le cas où le déphasage devient égal à $\varphi_o$. Il est donc possible d'annuler l'erreur de phase par la superposition, après accrochage de la PLL, d'une tension $e_3(t)$ dont la valeur permet d'obtenir une tension $e_1(t)$ représentative d'une erreur de phase nulle sans pour autant changer la tension $e_2(t)$, c'est-à-dire l'accrochage de la boucle. Il est indispensable que cette tension de décalage soit superposée après l'accrochage de la boucle. Dans cet objectif, le dispositif selon l'invention de la figure 4 comprend des moyens de retard 5, par exemple un interrupteur fermé au bout d'un temps $\tau$, le temps $\tau$ étant supérieur à la constante de temps de la boucle PLL. Lorsque l'accrochage est effectué, la tension de décalage $e_3(t)$ est alors superposée à la tension $e_1(t)$ par des moyens comportant par exemple un générateur de tension constante 6 et un additionneur de tension 7. La constante de temps de la PLL étant faible, la boucle va s'accrocher de nouveau très rapidement tout en modifiant la tension $e_1(t)$ jusqu'à ce qu'elle soit représentative d'une erreur de phase nulle.

La figure 5 est un autre mode de réalisation du dispositif selon l'invention, pour lequel l'annulation de l'erreur de phase s'effectue automatiquement. Ceci est rendu possible en commandant la tension de décalage $e_3(t)$ par la sortie du comparateur de phase 1, et par conséquent par l'erreur de phase $\Delta\varphi$ à annuler.

Le dispositif selon l'invention forme alors une seconde boucle imbriquée dans la PLL, et fonctionnant après l'accrochage de cette dernière. Les moyens de retard 5 sont par exemple constitués d'éléments résistifs et capacitifs qui confèrent à cette seconde boucle une grande constante de temps par rapport à la boucle principale de la PLL.

L'amplificateur 3 et l'additionneur 7 de la figure 4, peuvent être remplacés par un amplificateur opérationnel 3' recevant sur son entrée positive la tension $e_1(t)$ et sur son autre entrée, la tension de décalage $e_3(t)$. Les moyens 6 pour fournir la tension de décalage sont par exemple constitués d'un potentiomètre 8 et d'un amplificateur inverseur 9 recevant sur son autre entrée la tension issue des moyens de retard 5.

Le dispositif selon l'invention permet d'avoir au total l'efficacité d'une PLL dont le gain serait le produit des gains de la première boucle et de la seconde boucle, tout en bénéficiant d'une large plage d'accrochage.

Le procédé et le dispositif selon l'invention s'appliquent à la récupération de porteuse pour une détection synchrone, mais également à tout domaine où l'annulation de l'erreur de phase sur le déphasage d'une PLL est nécessaire.

**Revendications**

1. Procédé d'annulation de l'erreur de phase sur le déphasage entre le signal d'entrée et le signal de sortie d'une boucle à verrouillage de phase du type comportant en série un comparateur de phase (1) comparant la phase du signal d'entrée et du signal de sortie, un filtre de boucle (2) fournissant une tension $e_1(t)$ fonction de ladite erreur de phase, un amplificateur (3) de la tension $e_1(t)$ délivrant une tension $e_2(t)$, et un oscillateur (4), commandé par la tension $e_2(t)$ et générant ledit signal de sortie, le procédé étant caractérisé en ce qu'il consiste à superposer à la tension $e_1(t)$ issue du filtre de boucle une tension de décalage après accrochage de la boucle de façon à obtenir une tension $e_1(t)$ représentative d'une erreur de phase nulle tout en conservant la tension $e_2(t)$ constante.

2. Procédé d'annulation selon la revendication 1, caractérisé en ce que la tension de décalage est commandée par la tension issue du comparateur de phase (1) de façon à ce que l'annulation de l'erreur de phase soit automatique.

3. Dispositif d'annulation de l'erreur de phase sur le déphasage entre le signal d'entrée et le signal de sortie d'une boucle à verrouillage de phase du type comportant en série un comparateur de phase (1) comparant la phase du signal d'entrée et du signal de sortie, un filtre de boucle (2) fournissant une tension $e_1(t)$ fonction de ladite erreur de phase, un amplificateur (3) de la tension $e_1(t)$ délivrant une tension $e_2(t)$, et un oscillateur (4), commandé par la tension $e_2(t)$ et générant ledit signal de sortie, le dispositif étant caractérisé en ce qu'il comporte :
   - des moyens de retard (5) permettant son fonctionnement une fois que l'accrochage de la boucle est effectué ;
   - des moyens (6) pour générer une tension de décalage;
   - des moyens (7; 3') pour superposer à la tension $e_1(t)$ la tension de décalage, amenant ainsi la tension $e_1(t)$ à une valeur représentative d'une erreur de phase nulle tout en conservant la tension $e_2(t)$ constante.

4. Dispositif d'annulation selon la revendication 3, caractérisé en ce qu'il est commandé par la sortie du comparateur de phase (1), formant ainsi une seconde boucle.

5. Dispositif d'annulation selon la revendication 4, caractérisé en ce que les moyens de retard (5) sont constitués d'éléments capacitifs et résistifs pour donner à la seconde boucle une grande constante de temps.

6. Dispositif d'annulation selon l'une quelconque des revendications 3 à 5, caractérisé en ce que les moyens (6) pour générer la tension de décalage comprennent un potentiomètre (8) et un amplificateur inverseur (9).

FIG.1

FIG.2

FIG.3

4

FIG. 4

FIG.5

**Office européen des brevets**

## RAPPORT DE RECHERCHE EUROPEENNE

Numero de la demande

EP 92 40 2635

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | EP-A-0 438 620 (SIEMENS ATIENGESELLSCHAFT) * colonne 3, ligne 12 - ligne 29; figure 1 * | 1 | H03L7/093 |
| A | EP-A-0 181 439 (ANT NACHRICHTENTECHNIK GMBH) * abrégé; figure 1 * | 1-6 | |
| A | PATENT ABSTRACTS OF JAPAN vol. 5, no. 3 (E-40)(675) 10 Janvier 1981 & JP-A-55 134 541 ( FUJITSU K.K. ) 20 Octobre 1980 * abrégé * | 3,4 | |
| A | PATENT ABSTRACTS OF JAPAN vol. 7, no. 214 (E-199)21 Septembre 1983 & JP-A-58 107 727 ( FUJITSU K.K. ) 27 Juin 1983 * abrégé * | 3,4 | |
| A | PATENT ABSTRACTS OF JAPAN vol. 11, no. 275 (E-537)5 Septembre 1985 & JP-A-62 076 324 ( JAPAN RADIO CO LTD ) 8 Avril 1987 * abrégé * | 3,4 | **DOMAINES TECHNIQUES RECHERCHES (Int. Cl.5)** H03L |

Le présent rapport a été établi pour toutes les revendications

| Lieu de la recherche | Date d'achèvement de la recherche | Examinateur |
|---|---|---|
| LA HAYE | 12 NOVEMBRE 1992 | PEETERS M.M.G. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)